# EUROPEAN PATENT APPLICATION

(11) **EP 2 216 860 A1**
(43) Date of publication of application: **11.08.2010**
(21) Application number: 08846061.3
(22) Date of filing: 15.10.2008
(51) Int. Cl.: H01S 5/343, H01S 5/16, H01S 5/22

(54) **SEMICONDUCTOR LASER DEVICE**

(30) Priority: 02.11.2007 JP 2007285687
(71) Applicant: Panasonic Corporation, Kadoma-shi Osaka 571-8501 (JP)
(72) Inventor: KAWAGUCHI, Masao, Osaka 540-6207 (JP); YURI, Masaaki, Osaka 540-6207 (JP)
(74) Representative: Grünecker, Kinkeldey, Stockmair & Schwanhäusser Anwaltssozietät
(86) International application number: PCT/JP2008/002913
(87) International publication number: WO 2009/057254

(57) **Abstract**

A semiconductor laser device has a stacked structure formed on a main surface of a substrate (1) and including an MQW active layer (5) made of a group-III nitride semiconductor. The stacked structure has a stripe-shaped waveguide formed on a main surface thereof. One of opposing facets of the waveguide is a light emitting facet. A first region having a forbidden band width Eg1 in the MQW active layer (5), and a second region located adjacent to the first region and having a forbidden band width Eg2 in the MQW active layer (5) (where Eg2 ≠ Eg1) are formed around the recess (2). The waveguide is formed so as to include the first region and the second region, and so as not to include the stepped region. The light emitting facet is formed in one (5a) of the first region and the second region, which has a shorter light absorption wavelength.

## Description

### TECHNICAL FIELD

The present invention relates to a semiconductor laser device using a group-III nitride semiconductor, that is, a gallium nitride (GaN)-based compound semiconductor.

### BACKGROUND ART

Semiconductor laser devices have superior characteristics such as a small size, low cost, and high power. Thus, the semiconductor laser devices have been used in a wide range of technical fields such as a medical field and an illumination field, in addition to information communication technology (IT technology) such as communication applications and optical disc applications. In recent years, progress has been made especially on 405 nm-wavelength GaN-based semiconductor laser devices which are used in Blu-ray discs and the like. Moreover, GaN-based semiconductor laser devices capable of outputting pure-blue laser light in the wavelength range of 450 nm to 470 nm have been developed for use in laser displays and backlight sources of liquid crystal displays.

These GaN-based semiconductor devices have been required to have higher power for high-speed, multilayer recording in optical disc applications. In addition, these GaN-based semiconductor devices have been required to have higher power for higher brightness in display applications and backlight applications. In order to implement higher power semiconductor laser devices, it is especially important to suppress a degradation mode called "facet degradation" in which light emitting facets of the cavity generating laser light are degraded by laser light.

Hereinafter, the facet degradation will be described.

A chemical reaction, which occurs between atoms forming the cavity facets of a semiconductor laser device, in particular, the light-emitting facets, and atoms forming a coating material deposited on the cavity facets or atoms existing as an atmosphere around the laser device, increases crystal incompleteness which causes laser light absorption in the light-emitting facets. As the crystal incompleteness increases in the light-emitting facets, the light absorption increases, and thus, most of the absorbed light, resulting in heat, raises the temperature of the facets. Such temperature rise reduces the band gap of the semiconductor, which further increases light absorption, and thus, raises the temperature, causing positive feedback. This positive feedback results in a failure called catastrophic optical damage (COD) which melts crystal at the facets.

Conventionally, a facet window structure has been used in GaAs-based semiconductor laser devices in order to overcome the facet degradation problem. The facet window structure is a structure which makes the forbidden band width near the light-emitting facets in an active layer larger than that in the remaining region in the cavity. This structure reduces light absorption near the light-emitting facets, and thus, reduces heat generation at the light-emitting facets, whereby the facet degradation can be suppressed.

In conventional GaAs-based semiconductor laser devices, a technique of disordering an active layer by using ion implantation or impurity diffusion has been used to form a facet window structure (see, e.g., Patent Document 1 and Patent Document 2).

For example, in an ion implantation method, ions are implanted into an active layer and the vicinity thereof, and heat treatment is performed thereafter. Due to thermal diffusion of the implanted ions and defects associated with the implantation, a semiconductor material in the active layer having a small forbidden band width is mixed with a semiconductor material in the surrounding region having a large forbidden band width, whereby the active layer is disordered. As a result, the active layer has a larger forbidden band with than before the implantation, whereby laser light absorption is reduced. Moreover, in the case of an impurity diffusion method, metal impurities or the like having a large diffusion constant, which are provided above a facet window portion, are thermally diffused. The thermally diffused impurities disorder an active layer, whereby the forbidden band width of the active layer is increased, and light absorption is reduced.
Patent Document 1: Japanese Published Patent Application No. 63-164288
Patent Document 2: Japanese Published Patent Application No. 63-196088

### DISCLOSURE OF THE INVENTION

### PROBLEMS TO BE SOLVED BY THE INVENTION

In GaN-based semiconductor laser devices, however, bonding of a GaN crystal is strong, and implanted ions or impurities have a small diffusion constant. It is therefore difficult to form a facet window structure by the ion implantation method or the impurity diffusion method. Accordingly, a laser structure having a facet window structure has not been practically used in the GaN-based semiconductor laser devices.

It is an object of the present invention to solve the above conventional problems and to implement, without using ion implantation or impurity diffusion, a facet window structure in a semiconductor laser device made of a GaN-based semiconductor so that facet degradation can be prevented.

### MEANS FOR SOLVING THE PROBLEMS

In order to achieve the above object, a semiconductor laser device according to the present invention is structured so that a stepped region is formed in a part of a stacked structure made of a group-III nitride semiconductor including a laser structure, and the stepped region is located at least near a light emitting facet and on a lateral side of a waveguide.

As a result of various studies, the inventors have found that, in the case where a GaN-based semiconductor including a laser structure is grown after a stepped region is formed in a part of a substrate, the forbidden band width of a region near the stepped region in an active layer becomes different from that of a region located away from the stepped region. By providing a light emitting facet of the laser device in a region having a large forbidden band width, a GaN-based semiconductor laser device which has a facet window structure having a large forbidden band width at a light emitting facet can be formed.

The present invention was developed based on this finding, and specifically, is implemented by the following structure.

A semiconductor laser device according to the present invention includes a stacked structure having each layer made of a group-III nitride semiconductor, including an active layer, and having a stepped region selectively formed therein. The stacked structure has a stripe-shaped waveguide extending in a plane parallel to a main surface of the stacked structure. At least one of opposing facets of the waveguide is a light emitting facet. A first region having a forbidden band width Eg1 in the active layer, and a second region located adjacent to the first region and having a forbidden band width Eg2 in the active layer (where Eg2 # Eg1) are formed around the stepped region. The waveguide is formed so as to include the first region and the second region, and so as not to include the stepped region. The light emitting facet is formed in one of the first region and the second region, which has a shorter light absorption wavelength.

According to the semiconductor laser device of the present invention, the first region having the forbidden band width Eg1 in the active layer, and the second region located adjacent to the first region and having the forbidden band width Eg2 in the active layer (where Eg2 # Eg1) are formed around the stepped region in the stacked structure having the stepped region formed therein. The waveguide is formed so as to include the first region and the second region, and so as not to include the stepped region. The light emitting facet is formed in one of the first region and the second region, which has a shorter light absorption wavelength. This implements a GaN-based semiconductor laser device having a facet window structure presenting small laser light absorption at the light emitting facet.

It is preferable that the semiconductor laser device of the present invention further include a substrate for crystal-growing the stacked structure thereon, and the stepped region be formed by a recess or a protrusion which is formed in a main surface of the substrate.

In the semiconductor laser device of the present invention, it is preferable that the forbidden band width Eg1 of the first region be larger than the forbidden band width Eg2 of the second region.

In the semiconductor laser device of the present invention, it is preferable that a tilt angle of the first region with respect to a crystal plane in the main surface of the stacked structure be different from a tilt angle of the second region with respect to the crystal plane.

It is known that, in GaN-based mixed crystal growth, the off angle of a growth plane affects the composition. For example, it is known that, in the case of growing a mixed crystal of indium gallium nitride (InGaN) on gallium nitride (GaN) having a (0001) plane as a main surface, the In composition significantly decreases as the off angle with respect to the (0001) plane increases. When a GaN-based mixed crystal is grown on a substrate having a stepped region, the crystal plane is tilted near the stepped region, and the off angle changes. Moreover, the area of the region where the off angle changes and the off angle can be controlled by adjusting the height and the shape of the stepped region. In other words, since the composition ratio of the GaN-based mixed crystal, for example, the In composition of InGaN, changes according to the off angle, the forbidden band width can be controlled. In this way, a GaN-based semiconductor laser device having a facet window region can be implemented by forming the two regions having different forbidden band widths, that is, the first region located near the stepped region and the second region located away from the stepped region, and forming a laser structure having one of the regions having a shorter light absorption wavelength as a facet.

In the semiconductor laser device of the present invention, it is preferable that a height of the first region in the main surface of the stacked structure be different from a height of the second region.

In the case where the first region and the second region are continuous, a region tilted when viewed from the second region, that is, a region having a different off angle, is formed in at least a part of the first region. In the region having a different off angle, the In composition of InGaN, for example, changes, and therefore, regions having different forbidden band widths can be formed. A GaN-based laser device having a facet window structure can be formed by forming a light emitting facet in a region having a larger forbidden band width of the regions having different forbidden band widths, that is, a region having a shorter light absorption wavelength.

In the semiconductor laser device of the present invention, it is preferable that the active layer contain indium (In) in its composition.

Adding indium (In) to a GaN-based semiconductor reduces the forbidden band width. In other words, the use of InGaN in the laser active layer enables the oscillation wavelength of laser light to be increased. InGaN has therefore been used as an active layer material in 405 nm-wavelength blue-violet laser devices for discs, and 440 nm to 470 nm-wavelength pure-blue laser devices. As described above, in a GaN-based crystal containing In, i.e., an InGaN-based crystal, the In composition can be controlled by the off angle. Applying the present invention to an InGaN-based semiconductor laser device enables not only the blue-violet laser devices having a facet window structure for use in discs, but also the pure-blue laser devices capable of being used in, for example, illumination applications or backlight applications, and the like to be implemented.

In the semiconductor laser device of the present invention, it is preferable that the stepped region be formed in only one lateral region with respect to the waveguide.

The studies of the inventors show that, when two or more stepped regions are located close to each other, the region where the forbidden band width changes is not formed in a region between the stepped portions, and the facet window structure cannot be formed. Therefore, in the case of providing two or more stepped regions, it is desirable to form the stepped regions sufficiently away from each other.

In the semiconductor laser device of the present invention, it is preferable that the substrate be made of a group-III nitride semiconductor which belongs to a hexagonal system having a c-plane as a main surface, and the waveguide be formed along a normal vector of an m-plane in a plane parallel to the c-plane.

Currently, GaN-based semiconductor laser devices using a c-plane of a hexagonal GaN-based substrate as a main surface are widely used in Blu-ray disc applications and the like. In these laser devices, the m-plane is a natural cleavage plane of the crystal. Therefore, a stripe-shaped waveguide extends along the normal vector of the m-plane, and the cavity facet is formed by cleaving the m-plane. With the above structure, the facet window structure can be introduced to the currently widely used blue-violet laser devices for Blu-ray discs. Therefore, high-speed write operation and high reliability can be implemented.

In this case, it is preferable that the waveguide be formed in a region located at a distance of about 2 µm to about 10 µm from an edge of the stepped region.

The studies of the inventors show that the change in forbidden band width becomes the largest in the region located about 2 µm to about 10 µm away from the edge of the stepped region. A GaN-based semiconductor laser device with a facet window structure having a large difference in forbidden band width between the formation region of the facet window structure and the remaining region, that is, having further reduced light absorption in the laser light window region, can be formed by providing the stripe-shaped waveguide in the region where the change in forbidden band width is the largest.

The stepped region may be formed on a same side as that of the recess or the protrusion formed in the main surface of the substrate, with respect to the waveguide.

### EFFECTS OF THE INVENTION

According to a semiconductor laser device of the present invention, a facet window structure can be formed without using ion implantation or impurity diffusion. Therefore, a high power, highly reliable GaN-based semiconductor laser device capable of preventing facet degradation can be implemented.

### BRIEF DESCRIPTION OF THE DRAWINGS

FIGS. 1(a) through 1(c) show a blue-violet semiconductor laser device according to an embodiment of the present invention, where FIG. 1(a) is a plan view, FIG. 1(b) is a sectional structural diagram taken along line Ib-Ib in FIG. 1(a), and FIG. 1(c) is a right side view.

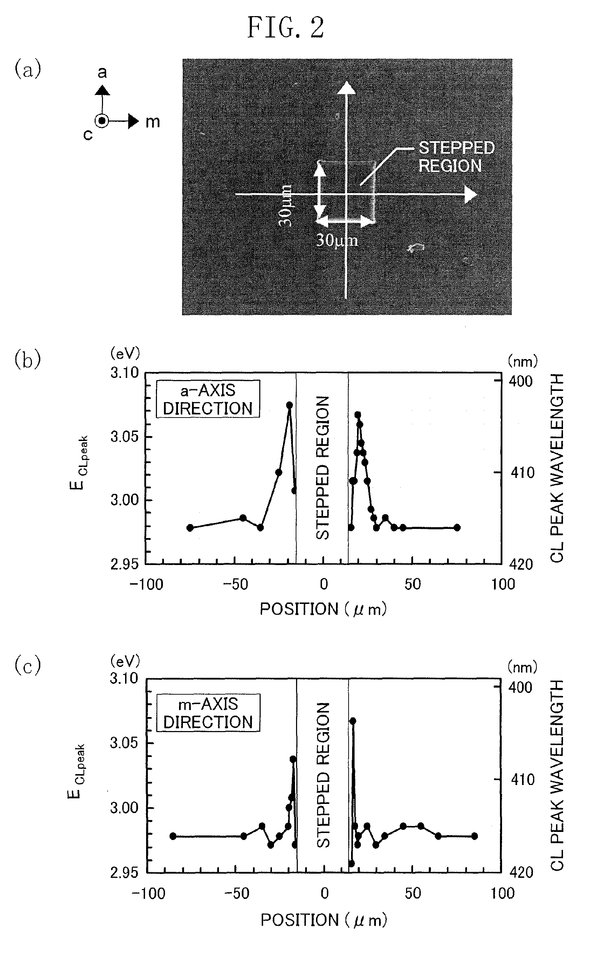

FIG. 2(a) is a scanning electron microscope (SEM) image of an upper surface of a stepped region and the vicinity thereof after an active layer in the blue-violet semiconductor laser device according to the embodiment of the present invention was grown. FIG. 2(b) is a graph showing the position dependency in an a-axis direction of CL peak energy (wavelength), where the central position of the stepped region of FIG. 2(a) is located at the origin. FIG. 2(c) is a graph showing the position dependency in an m-axis direction of CL peak energy (wavelength), where the central position of the stepped region of FIG. 2(a) is located at the origin.
FIG. 3(a) is an enlarged graph showing the vicinity of the stepped region of FIG. 2(b), and FIG. 3(b) is an enlarged graph showing the vicinity of the stepped region of FIG. 2(c).
FIG. 4 is a plan view of another blue-violet semiconductor laser device according to the embodiment of the present invention.
FIG. 5 is a graph showing the result of measuring, with a profilometer, the height in the vicinity of a stepped region in a stacked structure of a violet semiconductor laser device according to an embodiment of the present invention, and the off angle estimated from the height.
FIG. 6 is a graph showing the calculated values and experimental values of the emission energy of the active layer estimated from the change in off angle shown in FIG. 5.
FIGS. 7(a) through 7(c) show a blue-violet semiconductor laser device according to a first modification of the embodiment of the present invention, where FIG. 7(a) is a plan view, FIG. 7(b) is a sectional structural diagram taken along line VIIb-VIIb in FIG. 7(a), and FIG. 7(c) is a right side view.
FIGS. 8(a) through 8(c) show a blue-violet semiconductor laser device according to a second modification of the embodiment of the present invention, where FIG. 8(a) is a plan view, FIG. 8(b) is a sectional structural diagram taken along line VIIIb-VIIIb in FIG. 8(a), and FIG. 8(c) is a right side view.
FIGS. 9(a) through 9(c) show a blue-violet semiconductor laser device according to a third modification of the embodiment of the present invention, where FIG. 9(a) is a plan view, FIG. 9(b) is a sectional structural diagram taken along line IXb-IXb in FIG. 9(a), and FIG. 9(c) is a right side view.

### DESCRIPTION OF THE REFERENCE NUMERALS

- 1: substrate
- 1a: recess (substrate)
- 1b: protrusion
- 2: recess (stacked structure)
- 3: n-type cladding layer
- 4: n-side optical guide layer
- 5: multiple quantum well (MQW) active layer
- 5a: region having a large forbidden band width (a region having a short light absorption wavelength)
- 7: p-side optical guide layer
- 8: carrier overflow suppressing layer
- 9: p-type cladding layer 10 p-type contact layer
- 12: insulating layer
- 13: p-side electrode
- 14: wiring electrode
- 15: pad electrode
- 16: n-side electrode
- 20: protrusion (stacked structure)

### BEST MODE FOR CARRYING OUT THE INVENTION

### (Embodiment)

A semiconductor laser device according to an embodiment of the present invention will be described with reference to the accompanying drawings.

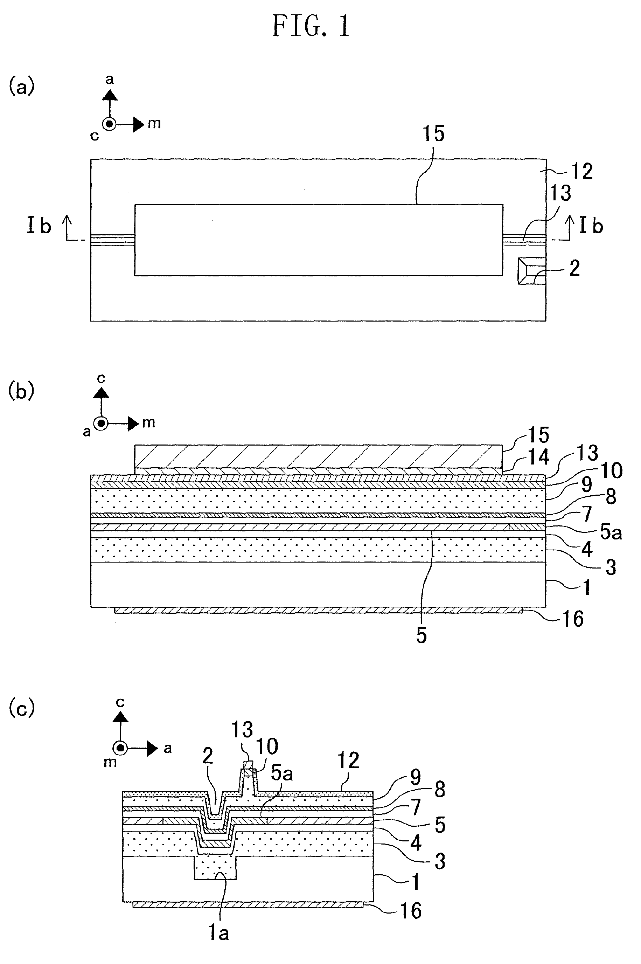

FIGS. 1(a) through 1(c) show a blue-violet semiconductor laser device according to an embodiment of the present invention, where FIG. 1(a) shows a planar structure, FIG. 1(b) shows a sectional structure taken along line Ib-Ib in FIG. 1(a), and FIG. 1(c) shows a structure of a right side surface (light emitting facet).

As shown in FIGS. 1(a) through 1(c), the semiconductor laser device of the present embodiment is a blue-violet semiconductor laser device using a hexagonal system GaN-based semiconductor and emitting light having a wavelength of 405 nm. The semiconductor laser device has a light emitting facet in a region 5a having a large forbidden band width, which is formed near a recess 2 forming a stepped region.

In FIGS. 1(a) through 1(c), orientations in a hexagonal GaN-based crystal are shown by "c," "a," and "m," where "c" indicates a normal vector of a (0001) plane, that is, a c-axis, and "a" indicates a normal vector of a (11-20) plane and a plane equivalent thereto, that is, an a-axis, and "m" indicates a normal vector of a (1-100) plane and a plane equivalent thereto, that is, an m-axis. In the specification, the negative sign "-" added to the Miller indices in the orientations conveniently represents inversion of the index following the negative sign.

Hereinafter, the structure of the blue-violet semiconductor laser device according to the present embodiment and a manufacturing method thereof will be described.

First, as shown in FIGS. 1(b) and 1(c), a first mask film (not shown) made of silicon oxide (SiO₂) is deposited with a thickness of 600 nm on a main surface of a substrate 1 made of n-type gallium nitride (GaN) by a thermal chemical vapor deposition (thermal CVD) method using, for example, silane (SiH₄) as a material. The substrate 1 has a (0001) plane as the main surface. Then, an opening having a 30 µm × 30 µm square shape in plan is formed in the first mask film by a lithography method and an etching method so that two adjacent sides are parallel to the a-axis and the m-axis, respectively.

Then, the substrate 1 is etched by an inductively coupled plasma (ICP) etching apparatus using carbon tetrafluoride (CF₄) as an etching gas, whereby a recess 1a having a depth of about 2 µm is formed in the first substrate 1 through the opening of the first mask film. The first mask film is then removed by using hydrofluoric acid (HF).

Then, an n-type cladding layer 3 made of n-type A1₀.₀₃Ga₀.₉₇N is grown with a thickness of 2 µm over the whole main surface of the substrate 1 including the recess 1a by, for example, a metalorganic chemical vapor deposition (MOCVD) method. An n-side optical guide layer 4 made of n-type GaN is then grown with a thickness of 0.1 µm on the n-type cladding layer 3. Moreover, a multiple quantum well (MQW) active layer 5 is grown on the n-side optical guide layer 4 by, for example, laminating three cycles of stacked structures each made of an In_{0.02}Ga_{0.98}N barrier layer and an In_{0.06}Ga_{0.94}N quantum well layer. At this time, a forbidden band width Eg2 of a region of the MQW active layer 5. located away from above the recess 1a is smaller than a forbidden band width Eg1 of a region of the MQW active layer 5 located near above the recess la, that is, Eg2 < Eg1. In this manner, according to the present invention, the light emitting facet of the MQW active layer 5 is provided in the region 5a having a large forbidden band width, which is produced by the stepped region formed by the recess 1a, as shown in the light emitting facet of FIGS. 1(b) and 1(c). As a result, a facet window structure can be implemented without using ion implantation or impurity diffusion. Note that the phenomenon in which the region 5a having a large forbidden band width is formed in the MQW active layer 5 by the stepped region will be described later in detail.

Then, a p-side optical guide layer 7 made of p-type GaN is grown with a thickness of 0.1 µm on the MQW active layer 5. An Al_{0.20}Ga_{0.80}N carrier overflow suppressing layer (OFS layer) 8 is then grown with a thickness of 10 nm on the p-side optical guide 7. A p-type cladding layer 9 having a strained superlattice structure and a p-type contact layer 10 made of p-type GaN are then sequentially grown with a thickness of 0.48 µm and 0.05 µm, respectively, on the OFS layer 8. The p-type cladding layer 9 is formed by laminating 160 cycles of stacked structures each made of a 1.5 nm-thick p-type Al_{0.16}G_{0.84}N layer and a 1.5 nm-thick GaN layer.

As shown in FIG. 1(c), the recess 2 formed in an epitaxial layer (stacked structure) including the MQW active layer 5 grows so as to fill the recess 1a formed in the substrate 1. Therefore, the width and the depth of the recess 2 may become smaller than the shape of the recess 1a. Moreover, depending on the growth conditions of the stacked structure, the recess 2 may be completely filled and become flat. Even in that case, this structure can be used as a facet widow structure as long as the region 5a above the recess 1a in the MQW active layer 5 has a shorter light absorption wavelength by the influence of the recess 1a formed in the substrate 1, that is, as long as the forbidden band width Eg1 of the region 5a is larger than the forbidden band width Eg2 of the remaining region of the MQW active layer 5.

Note that, in order to use this structure as a facet window structure, the forbidden band width Eg1 of the region 5a is preferably larger than the forbidden band width Eg2 of the remaining region by 50 meV or more. More preferably, the forbidden band width Eg1 of the region 5a is larger than the forbidden band width Eg2 of the remaining region by 100 meV or more, and more preferably, 150 meV or more. It should be noted that the difference between Eg1 and Eg2 is equal to or less than the difference between the "forbidden band width (Eg1) of the active layer (containing In and Ga and N) contributing to light emission" and the "forbidden band width in the case where In is not present in the active layer contributing to light emission (e.g., in the case where In is completely replaced with Ga)." For example, in the case of a blue-violet laser device (wavelength: about 405 nm), the difference between Eg1 and Eg2 does not exceed about 330 meV. In the case of a green laser device (wavelength: about 540 nm), the difference between Eg1 and Eg2 does not exceed about 1,100 meV. It should be noted that laser devices other than the blue-violet laser device and the green laser device are not limited to this.

Moreover, the width in the a-axis direction of the substrate 1 may be, for example, about 200 µm to about 400 µm. The length of one side in the m-axis direction of the recess 1a formed in the substrate 1 may be, for example, about 5 µm to about 200 µm, or about 50 µm to about 200 µm. Moreover, the length of one side in the a-axis direction of the recess 1 a is preferably, for example, about 20 µm to about 100 µm, and may be about 2 µm to about 200 µm, or about 2 µm to about 100 µm. Moreover, the depth of the recess 1a is preferably, for example, about 0.1 µm to about 10 µm, and the depth of the recess 2 formed in the stacked structure is preferably, for example, about 0.01 µm to about 10 µm.

In addition to the MOCVD method, a growth method capable of growing a GaN-based blue-violet semiconductor laser structure, such as a molecular beam epitaxy (MBE) method or a chemical beam epitaxy (CBE) method, may be used as a crystal growth method to form the stacked structure. In the case of using the MOCVD method, for example, trimethylgallium (TMG), trimethylindium (TMI), and trimethylaluminum (TMA) may be used as a Ga material, an In material, an Al material, respectively, and ammonia (NH₃) may be used as a N material. Moreover, a silane (SiH₄) gas can be used as a Si material as n-type impurities, and bis(cyclopentadienyl)magnesium (Cp₂Mg) can be used as a Mg material as p-type impurities.

Then, by, for example, a thermal CVD method, a second mask film (not shown) made of SiO₂ is deposited with a thickness of 0.3 µm on the p-type contact layer 10. The second mask film is patterned into a 1.5 µm-wide stripe shape parallel to the m-axis direction by a lithography method and an etching method.

Then, by using the second mask film, an upper part of the stacked structure is etched to the depth of 0.35 µm by an ICP method, thereby forming a ridge stripe portion from the p-type contact layer 10 and an upper part of the p-type cladding layer 9. The second mask film is then removed with hydrofluoric acid, and an insulating film (passivation film) 12 made of SiO₂ is again formed with a thickness of 200 nm on the whole surface of the exposed p-type cladding layer 9 including the ridge stripe portion by a thermal CVD method.

Then, by a lithography method, a resist pattern (not shown) having a 1.3 µm-wide opening along the ridge stripe portion is formed over an upper surface of the ridge stripe portion in the insulating film 12. Then, by using the resist pattern as a mask, the insulating film 12 is etched by reactive ion etching (RIE) using, for example, a methane trifluoride (CHF₃) gas, thereby exposing the p-type contact layer 10 from the upper surface of the ridge stripe portion.

Then, by, for example, an electron beam (EB) vapor deposition method, a metal laminated layer, which is made of 40 nm-thick palladium (Pd) and 35 nm-thick platinum (Pt), is formed at least on the p-type contact layer 10 exposed from the upper surface of the ridge stripe portion. The region of the metal laminated film other than the ridge stripe portion is then removed by a lift-off method for removing the resist pattern, thereby forming a p-side electrode 13.

Then, as shown in FIG. 1(b), a wiring electrode 14 is selectively formed on the insulating film 12 by a lithography method and a lift-off method so as to cover the p-side electrode 13 in the upper part of the ridge stripe portion. For example, the wiring electrode 14 has a planar dimension of 500 µm in the direction parallel to the ridge stripe portion, and has a planar dimension of 150 µm in the direction perpendicular to the ridge stripe portion. The wiring electrode 14 is herein formed by a metal laminated layer of titanium (Ti)/platinum (Pt)/gold (Au) having a thickness of 50 nm, 200 nm, and 100 nm, respectively. Note that, typically, the substrate 1 is in a wafer state, and a plurality of laser devices are formed in a matrix pattern on the main surface of the substrate 1. Therefore, if the wiring electrode 14 is cut when dicing the substrate 1 in a wafer state into individual laser chips, the p-side electrode 13 in close contact with the wiring electrode 14 may peel off from the p-type contact layer 10. Accordingly, it is desirable that the wiring electrodes 14 of adjacent chips are connected to each other as shown in FIG. 1(a). Moreover, the thickness of the Au layer as the upper layer of the wiring electrode 14 is increased to about 10 µm by an electroplating method to form a pad electrode 15. This enables a laser chip to be mounted by wire bonding, and also enables the heat generated in the MQW active layer 5 to be efficiently released. As a result, reliability of the semiconductor laser device can be improved.

After the pad electrode 15 is formed, the back surface of the substrate 1 in a wafer state is polished by diamond slurry until the thickness of the substrate 1 is reduced to about 100 µm. Then, a metal laminated film, which is made of 5 nm-thick Ti, 10 nm-thick platinum, and 1,000 nm-thick Au, is formed on the back surface of the substrate 1 by, for example, an EB vapor deposition method to form an n-side electrode 16.

Next, the substrate 1 in a wafer state is primarily cleaved along an m-plane so that the length in the m-axis direction becomes 600 µm. It should be noted that, in this primary cleavage, the substrate 1 is cleaved so as to include the region 5a of the MQW active layer 5 in which the absorption wavelength is reduced, that is, the forbidden band width is increased, by the recess 1a formed in the substrate 1, thereby forming a facet window structure. The primarily cleaved substrate 1 is then secondarily cleaved along an a-plane so that the length in the a-axis direction becomes 200 µm.

Hereinafter, the phenomenon in which the forbidden band width is changed by forming the stepped region by the recess 1a near the light emitting facet in the laser structure made of a GaN semiconductor layer and including the MQW active layer 5 will be described.

FIG. 2(a) is a scanning electron microscope (SEM) image of an upper surface of the stepped region formed by the recess 2 and the vicinity thereof after the MQW active layer 5 was grown. FIG. 2(b) indicates CL peak energy (the left ordinate) obtained by line-scanning a cathode luminescence (CL) spectrum in the a-axis direction, where the central position of the stepped region of FIG. 2(a) is located at the origin. FIG. 2(c) indicates CL peak energy (the left ordinate) obtained by line-scanning a CL spectrum in the m-axis direction, where the central position of the stepped region is similarly located at the origin. In FIGS. 2(b) and 2(c), the right ordinate indicates the light wavelength corresponding to the CL peak energy. As shown in FIGS. 2(b) and 2(c), a region where the CL peak energy increases exists near the stepped region both in the a-axis direction and the m-axis direction. In general, the emission peak energy becomes high if the forbidden band width is large. In this case, the light absorption wavelength becomes short.

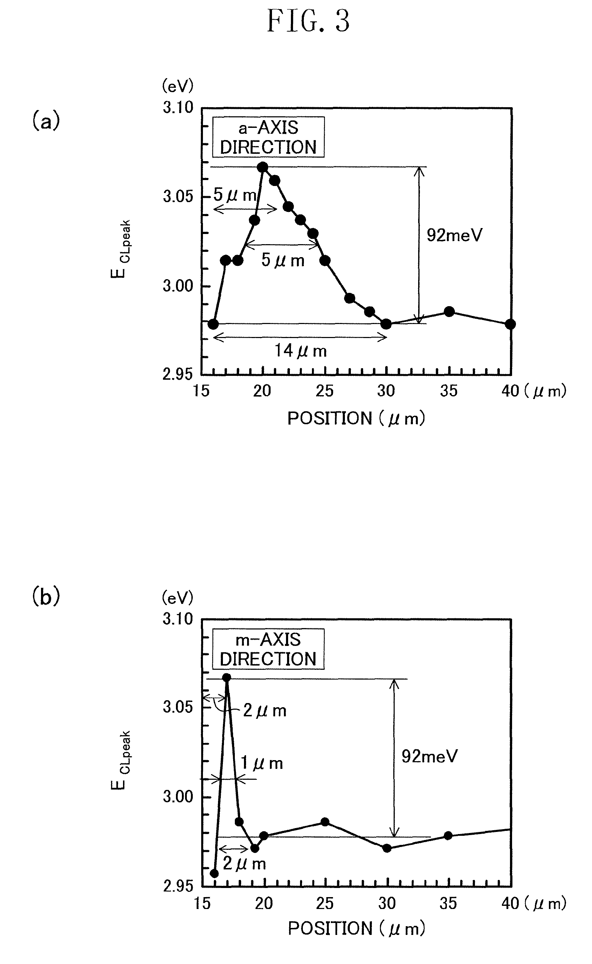

FIGS. 3(a) and 3(b) show, in enlargement, the vicinity of the stepped region of FIGS. 2(b) and 2(c), respectively. In the present embodiment, since the center of the 30 µm × 30 µm stepped region (recess 2) is located at the origin, the position of 15 µm on the abscissa in the figures corresponds to the edge of the stepped region. The largest value of the change in CL peak energy is the same in the a-axis and the m-axis, which is about 92 meV. However, the width of the region where the CL peak energy changes is different between the a-axis and the m-axis, which is about 14 µm in the a-axis direction shown in FIG. 3(a), and about 2 µm in the m-axis direction shown in FIG. 3(b).

Moreover, in the a-axis direction, the CL peak energy is the highest in the region located about 5 µm away from the edge of the stepped region. Therefore, a stripe-shaped waveguide is desirably formed at a distance of about 5 µm from the stepped region in the a-axis direction so as to extend parallel to the m-axis direction. In a hexagonal system GaN-based material, the m-plane is a natural cleavage plane. With the above structure, by cleaving the substrate near the stepped region so that the shorter-wavelength region is included and so that the m-plane is exposed, a structure having the largest CL peak energy at the light-emitting facet, that is, having the smallest laser light absorption at the light emitting facet, can be obtained. Note that the stripe-shaped waveguide may be formed at a distance of about 1 µm to about 15 µm, or about 2 µm to about 10 µm, from the stepped region in the a-axis direction so as to extend parallel to the m-axis direction.

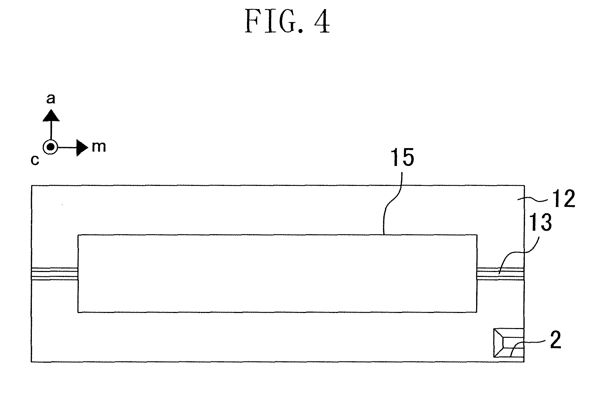

In the present embodiment, each side of the recess 1a formed in the substrate 1 to form the stepped region is parallel to the a-axis and the m-axis, and the depth of the recess 1a is 2µm. However, the position where the change in CL peak energy becomes the largest in the stacked structure may vary depending on the planar dimension, the planar shape, and the depth of the recess 1a. For example, as shown in FIGS. 3(a) and 3(b), in the embodiment of the present invention, the region where the CL peak energy changes is in the range of 2 µm to 14 µm from the edge of the recess 1a. Depending on the shape of the recess 1a and the deposition conditions of the stacked structure, however, the region where the CL peak energy changes may be in the range of 1 µm to 100 µm from the edge of the recess 1a. In this case, a facet window structure having small light absorption can be formed by forming an optical waveguide so as to include the region where the change in CL peak energy is the largest, and cleaving the substrate in the region where the change is the largest. For example, in the case where the change in CL peak energy in the a-axis direction becomes the largest at 100 µm from the edge of the recess 1a, the recess 2 is formed farther away from the ridge stripe portion as compared to FIG. 1(a), as shown in FIG. 4.

The stepped region (or the recess 1a formed in the substrate 1) may be formed in a plane including the light emitting facet. Moreover, even if the stepped region (or the recess 1a formed in the substrate 1) is not formed in a plane including the light emitting facet, the stepped region may be formed near this plane as long as a region where the energy changes is present in the light emitting facet. In the case where the stepped region (or the recess 1a formed in the substrate 1) is not formed in the plane including the light emitting facet, the stepped region (or the recess 1a formed in the substrate 1) may be formed at a position of more than 0 µm to 20 µm, or more than 0 µm to 200 µm, from the plane including the light emitting facet.

Moreover, the inventors examined the In composition in the region where the CL peak energy is large and the region where the CL peak energy is small, by using an X-ray microanalyzer (electron probe micro-analysis: EPMA), and found that the In composition is small in the region where the CL peak energy is large, and the In composition is large in the region where the CL peak energy is small. The emission peak energy in InGaN becomes smaller as the In composition becomes larger. Therefore, it can be considered that the change in In composition causes the change in CL peak energy in the vicinity of the stepped region.

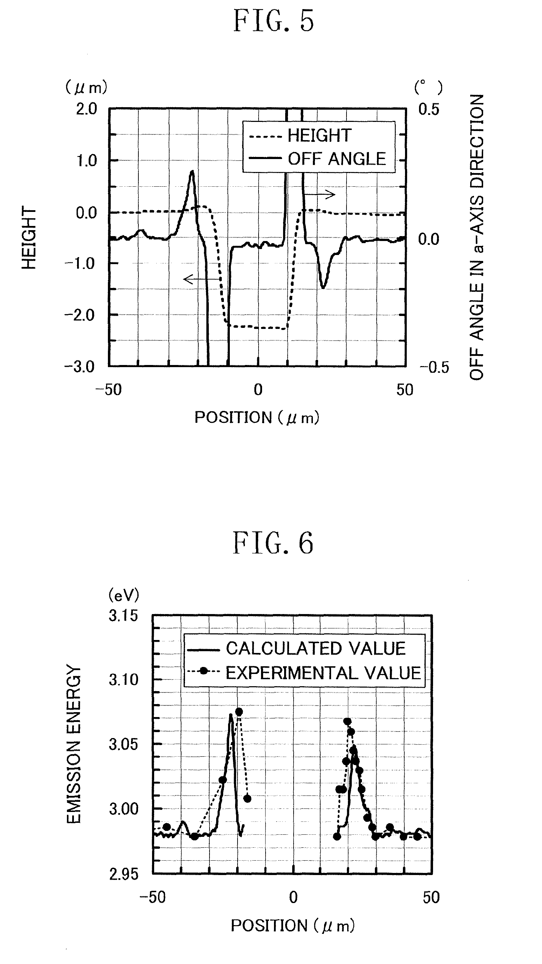

The height measurement was performed by a profilometer along the region where the CL spectrum was line-scanned as shown in FIGS. 2(b) and 2(c). The result shows that the vicinity of the stepped region in the stacked structure is slightly tilted in the region where the absorption wavelength changes. In FIG. 5, the height measurement result in the a-axis direction is shown on the left ordinate, and the tilt angle (off angle) to the a-axis direction, which was read from the change in height, is shown on the right ordinate. The result of the experiment carried out by the inventors shows that, in an InGaN-based material grown on a c-plane, the In composition decreases and the emission peak energy decreases as the off angle increases. FIG. 6 shows the emission energy of an InGaN active layer calculated from the off angle, and the CL peak energy obtained experimentally. As can be seen from FIG. 6, the position of the region where the energy changes approximately corresponds to the amount of change in energy. Therefore, it can be considered that increase in off angle near the stepped region in the laminated region deceases the In composition, thereby increasing the CL peak energy.

Note that the present embodiment was described with respect to the case where the emission peak energy is increased by the decrease in In composition due to the tilting near the stepped region in the stacked structure. However, the CL peak energy may be increased by another factor, such as decrease in In composition due to a phenomenon in which an In material is absorbed in the stepped region, or decrease in well width near the stepped region due to a phenomenon in which an In material and a Ga material are absorbed in the stepped region.

It is known that, in a hexagonal system GaN-based compound semiconductor, an internal electric field called a piezoelectric field is strongly generated when a semiconductor having a different lattice constant from that of GaN, such as InGaN, is laminated. The piezoelectric field bends the energy band of the semiconductor, and the emission peak energy decreases as a result. On the other hand, if carriers are injected into the laser structure for laser oscillation, the piezoelectric field is shielded by the injected carriers, and the emission peak energy increases.

Incidentally, a facet emission type semiconductor laser device may use a facet current non-injection structure in which no electrode is provided near the facets of the optical waveguide in order to reduce a current which is lost as heat by flowing in a light emitting facet and to prevent peeling-off of the electrode upon cleavage. In an InGaN/GaN-based semiconductor laser device having a piezoelectric field, however, the emission peak energy is small in the non-injection region, that is, light absorption is large in the non-injection region. Therefore, the use of the facet current non-injection structure may increase light absorption at the light emitting facet. Moreover, introduction of impurities such as Si, which are present in a furnace of a crystal growth apparatus, may increase near the stepped region. Such impurities function as, for example, donors of a GaN-based semiconductor, and generate carriers which shield the piezoelectric field. Therefore, in the vicinity of the stepped region of the stacked structure, the piezoelectric field is shielded even without performing current injection, and the emission peak energy increases as a result. Accordingly, by forming a facet window structure near the stepped region in a GaN-based semiconductor laser device having a piezoelectric field, the amount of light absorption at the light emitting facet can be increased while obtaining the effect of reducing a facet current in the current non-injection structure, and of suppressing peeling-off of an electrode.

Note that the present embodiment was described with respect to the structure in which the window region is provided in the light emitting facet of the optical waveguide. However, the window region may be provided in both opposing facets of the optical waveguide. Moreover, the planar dimension and the depth of the recess 1 a formed in the substrate 1 are not limited to those of the present embodiment if a region having a short light absorption wavelength is formed near the stepped region formed by the recess 1a, and this region can be used as a facet window.

Moreover, the present embodiment was described with respect to the example in which the region having a short light absorption wavelength is formed near the stepped region formed in the stacked structure including the laser structure. However, a region having a long light absorption wavelength may be formed depending on the growth conditions of the stacked structure or the off angle of the growth substrate. In this case, a region having a relatively short light absorption wavelength, which is not affected by the stepped region, can be used as a facet window region.

Moreover, if the substrate has an off angle in the a-axis direction, a region having a long light absorption wavelength may be formed on one side of the stepped region with respect to the a-axis, and a region having a short light absorption wavelength may be formed on the other side. In this case, a light emitting facet can be formed on the side of the short light absorption wavelength, or an optical waveguide can be formed on the side of the long light absorption wavelength, and a light emitting facet can be formed in a region having a short light absorption wavelength, which is located away from the stepped region.

Moreover, in the present embodiment, the recess 2 is formed in the stacked structure by forming the recess 1a in the main surface of the substrate 1. However, the present invention is not limited to this. That is, instead of forming the recess 1 in the substrate 1, the recess 2 may be formed by forming a recess in, for example, an intermediate layer of the stacked structure, and regrowing the remaining stacked structure so as to include the recess.

Moreover, in the present embodiment, the cavity length in the laser structure is 600 µm. However, the present invention is not limited to this, and the cavity length may be 200 µm to 20,000 µm (= 20 mm). The cavity length may be 400 µm to 1,000 µm (= 1 mm).

Moreover, in the present embodiment, a GaN-based substrate (a GaN substrate, an AlGaN substrate) which belongs to a hexagonal system was used as the growth substrate of the stacked structure. However, another substrate capable of growing a GaN-based material thereon, such as silicon carbide (SiC), silicon (Si), sapphire (single crystal Al₂O₃), or zinc oxide (ZnO), may be used as the growth substrate.

Moreover, in the present embodiment, the window structure is provided on only one facet of the semiconductor laser device. However, the window structure may be provided on both facets.

### (First Modification of the Embodiment)

Hereinafter, a semiconductor laser device according to a first modification of the embodiment of the present invention will be described with reference to the drawings.

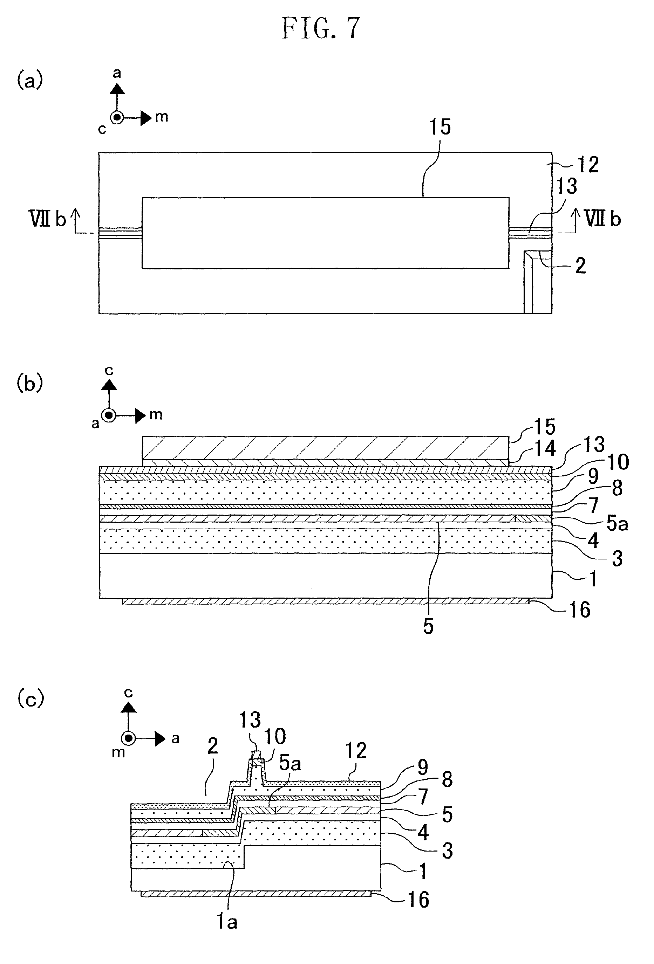

FIGS. 7(a) through 7(c) show a blue-violet semiconductor laser device according to the first modification of the embodiment of the present invention, where FIG. 7(a) shows a planar structure, FIG. 7(b) shows a sectional structure taken along line VIIb-VIIb in FIG. 7(a), and FIG. 7(c) shows a structure of a right side surface (light emitting facet). In FIG. 7, the same components as those of FIG. 1 are denoted with the same reference numerals and characters as those of FIG. 1, and description thereof will be omitted.

As shown in FIG. 7(c), in the blue-violet semiconductor laser device of the present modification, a recess 2 formed on one lateral region with respect to a waveguide extends to an end of the laser device to one direction of the a-axis direction (to the opposite side to the waveguide). The use of this structure enables the capacity of the recess 2 to be increased. Since the capacity of the recess 2 can be increased in this manner, the emission energy of the MQW active layer 5 located near the stepped portion can further be increased, and light absorption can further be reduced. In addition, since the region where the emission energy changes is increased, a facet window region can be stably formed with a high yield.

Note that since the method for forming the recess shown in FIG. 7 is the same as that in the manufacturing method of the blue-violet semiconductor laser device shown in FIG. 1, description thereof will be omitted.

### (Second Modification of the Embodiment)

Hereinafter, a semiconductor laser device according to a second modification of the embodiment of the present invention will be described with reference to the drawings.

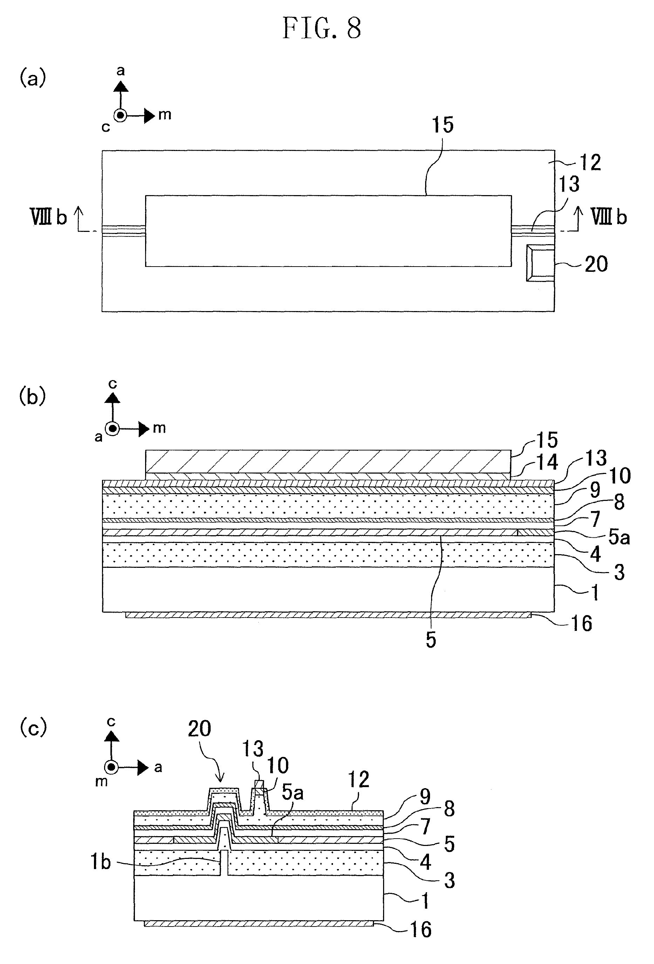

FIGS. 8(a) through 8(c) show a blue-violet semiconductor laser device according to the second modification of the embodiment of the present invention, where FIG. 8(a) shows a planar structure, FIG. 8(b) shows a sectional structure taken along line VIIIb-VIIIb in FIG. 8(a), and FIG. 8(c) shows a structure of a right side surface (light emitting facet). In FIG. 8, the same components as those of FIG. 1 are denoted with the same reference numerals and characters as those of FIG. 1, and description thereof will be omitted.

As shown in FIG. 8(c), a protrusion 1b is formed instead of the recess 1a in a substrate 1 for growing a stacked structure according to the second modification. The substrate 1 is made of a GaN-based semiconductor. The protrusion 1b has a 30 µm × 30 µm square shape in plan, and two adjacent sides of the protrusion 1b are parallel to the a-axis and the m-axis, respectively. The height of the protrusion 1b is 2 µm.

With this structure, a stepped region by a protrusion 20 is formed in a stacked structure epitaxially grown on a main surface of the substrate 1 including the protrusion 1b. Accordingly, by providing a light emitting facet of an MQW active layer 5 in a region 5a having a large forbidden band width formed by the stepped region, a facet window region can be formed without using ion implantation or impurity diffusion, as in the case of the above embodiment.

Note that, in the second modification, the window structure is provided on only one facet of the semiconductor laser device. However, the window structure may be provided on both facets.

Hereinafter, an example of a method for forming the protrusion 1b in the substrate 1 will be described.

First, a mask film (not shown) made of SiO₂ is deposited with a thickness of 600 nm on a main surface of the substrate 1 made of n-type GaN by a thermal CVD method using, for example, SiH₄ as a material. The substrate 1 has a (0001) plane as the main surface. Then, by a lithography method and an etching method, the mask film is patterned into a 30 µm × 30 µm square shape in plan so that two adjacent sides are parallel to the a-axis and the m-axis, respectively.

Next, an upper part of the substrate 1 having the mask film formed thereon is etched by an ICP etching apparatus using CF₄ as an etching gas, whereby a protrusion 1b having a height of 2 µm is formed in the substrate 1. The mask film is then removed with hydrofluoric acid.

Thereafter, by a MOCVD method or the like, a stacked structure having a similar structure to that of the embodiment is epitaxially grown on the main surface of the substrate 1 having the protrusion 1b formed therein, whereby a ridge stripe-type semiconductor laser device is fabricated.

Note that, in the present modification, the protrusion 20 is formed in the stacked structure by forming the protrusion 1b on the main surface of the substrate 1. However, the present invention is not limited to this. That is, instead of forming the protrusion 1b in the substrate 1, the protrusion 20 may be formed by forming a protrusion in, for example, an intermediate layer of the stacked structure, and regrowing the remaining stacked structure so as to include the protrusion.

The stepped region (or the protrusion 1b formed in the substrate 1) may be formed on a plane including a light emitting facet. Moreover, even if the stepped region (or the protrusion 1b formed in the substrate 1) is not formed in the plane including the light emitting facet, the stepped region (or the protrusion 1b formed in the substrate 1) may be formed near this plane as long as a region where the energy changes is present in the light emitting facet. In the case where the stepped region (or the protrusion 1b formed in the substrate 1) is not formed in the plane including the light emitting facet, the stepped region (or the protrusion 1b formed in the substrate 1) may be formed at a position of more than 0 µm to 20 µm, or more than 0 µm to 200 µm, from the plane including the light emitting facet.

### (Third Modification of the Embodiment)

Hereinafter, a semiconductor laser device according to a third modification of the embodiment of the present invention will be described with reference to the drawings.

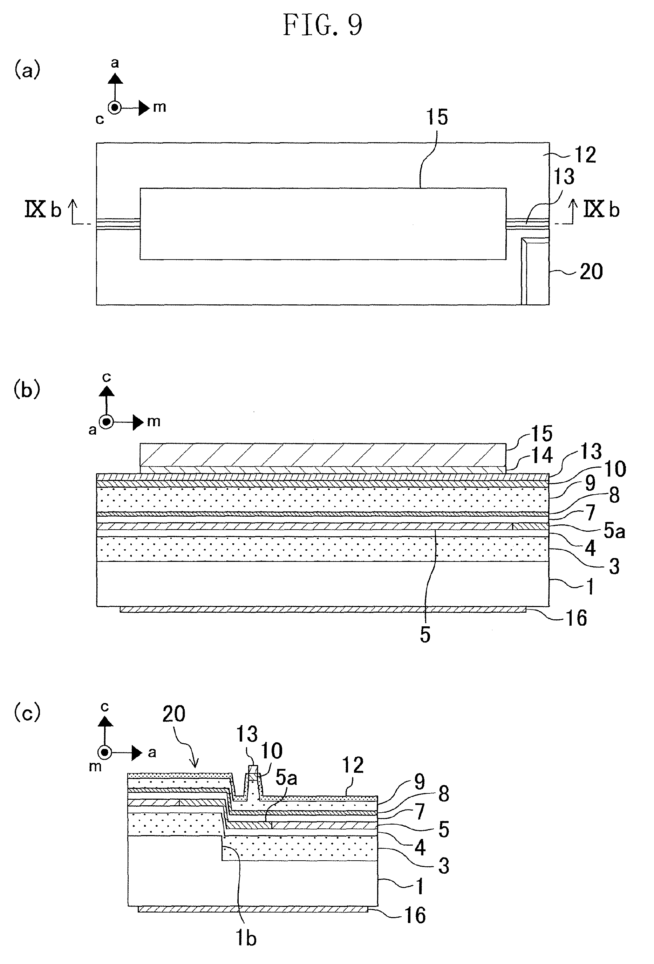

FIGS. 9(a) through 9(c) show a blue-violet semiconductor laser device according to the third modification of the embodiment of the present invention, where FIG. 9(a) shows a planar structure, FIG. 9(b) is a sectional structure taken along line IXb-IXb in FIG. 9(a), and FIG. 9(c) shows a structure of a right side surface (light emitting facet). In FIG. 9, the same components as those of FIG. 1 are denoted by the same reference numerals and characters as those of FIG. 1, and description thereof will be omitted.

As shown in FIG. 9(c), in the blue-violet semiconductor laser device of the present modification, the protrusion 1b extends to an end of the laser device in the a-axis direction. The use of this structure enables the volume of the protrusion 1b to be increased. This can further increase the emission energy of the MQW active layer 5 located near the stepped portion, and can further reduce light absorption. In addition, since the region where the emission energy changes is increased, a facet window region can be stably formed with a high yield.

Note that, since the method for forming the protrusion 1b shown in FIG. 9 is the same as that in the manufacturing method of the blue-violet semiconductor laser device shown in FIG. 8, description thereof will be omitted.

According to the embodiment of the present invention and the modifications thereof as described above, in the lamination structure including the laser structure made of a GaN-based semiconductor, the region 5a having a larger forbidden band width than that of the remaining region in the MQW active layer 5 is produced near the stepped region formed by the recess 1a or the protrusion 1b provided in the substrate 1. The light emitting facet is provided so as to include the region 5a having a large forbidden band width.

This enables the facet window structure to be formed without using ion implantation or impurity diffusion. Therefore, facet degradation can be prevented, and a high power, highly reliable GaN-based semiconductor laser device can be obtained.

Note that, in the embodiment of the present invention and each modification thereof, the length of one side in the m-axis direction of the recess 1a and the protrusion 1b formed in the substrate 1 may be, for example, about 5 µm to about 200 µm, or about 50 µm to about 200 µm. Moreover, the length of one side in the a-axis direction of the recess 1a and the protrusion 1b may be, for example, about 20 µm to about 100 µm, about 2 µm to about 200 µm, or about 2 µm to about 100 µm.

Moreover, the depth of the recess 1a or the height of the protrusion 1b may be, for example, about 0.1 µm to about 10 µm. The height of the protrusion 20 formed in the stacked structure may be, for example, about 0.01 µm to about 5 µm.

Moreover, the stripe-shaped waveguide may be formed at a distance of about 1 µm to about 15 µm, or about 2 µm to about 10 µm, from the stepped region in the a-axis direction so as to extend parallel to the m-axis direction.

### INDUSTRIAL APPLICABILITY

The semiconductor laser device of the present invention is useful for, for example, semiconductor laser devices using a GaN-based compound semiconductor, which can be used not only for light sources for recording and playback of optical discs, but also for laser displays or liquid crystal backlights, and for surgical laser scalpels, welding applications, and the like.

## Claims

1. A semiconductor laser device, comprising:
a stacked structure having each layer made of a group-III nitride semiconductor, including an active layer, and having a stepped region selectively formed therein, wherein
the stacked structure has a stripe-shaped waveguide extending in a plane parallel to a main surface of the stacked structure,
at least one of opposing facets of the waveguide is a light emitting facet,
a first region having a forbidden band width Eg1 in the active layer, and a second region located adjacent to the first region and having a forbidden band width Eg2 in the active layer (where Eg2 ≠ Eg1) are formed around the stepped region,
the waveguide is formed so as to include the first region and the second region, and so as not to include the stepped region, and
the light emitting facet is formed in one of the first region and the second region, which has a shorter light absorption wavelength.

2. The semiconductor laser device of claim 1, further comprising:
a substrate for crystal-growing the stacked structure thereon, wherein
the stepped region is formed by a recess or a protrusion which is formed in a main surface of the substrate.

3. The semiconductor laser device of claim 2, wherein
the substrate is made of a group-III nitride semiconductor which belongs to a hexagonal system having a c-plane as a main surface, and
the waveguide is formed along a normal vector of an m-plane in a plane parallel to the c-plane.

4. The semiconductor laser device of any one of claims 1 to 3, wherein
the forbidden band width Eg1 of the first region is larger than the forbidden band width Eg2 of the second region.

5. The semiconductor laser device of any one of claims 1 to 3, wherein
a tilt angle of the first region with respect to a crystal plane in the main surface of the stacked structure is different from a tilt angle of the second region with respect to the crystal plane.

6. The semiconductor laser device of any one of claims 1 to 3, wherein
a height of the first region in the main surface of the stacked structure is different from a height of the second region.

7. The semiconductor laser device of any one of claims 1 to 3, wherein
the active layer contains indium (In) in its composition.

8. The semiconductor laser device of any one of claims 1 to 3, wherein
the stepped region is formed in only one lateral region with respect to the waveguide.

9. The semiconductor laser device of any one of claims 1 to 3, wherein
the waveguide is formed in a region located at a distance of 2 µm to 10 µm from an edge of the stepped region.

10. The semiconductor laser device of claim 2, wherein
the stepped region is formed on a same side as that of the recess or the protrusion with respect to the waveguide.
